# EUROPEAN PATENT APPLICATION

(11) **EP 2 730 610 A1**
(43) Date of publication of application: **14.05.2014**
(21) Application number: 12807898.7
(22) Date of filing: 05.07.2012
(51) Int. Cl.: C08L 23/00, C09K 11/00, C09K 11/08, C09K 11/56, C09K 11/59, C09K 11/62, H01L 33/50

(54) **RESIN COMPOSITION FOR FORMING FLUORESCENT SHEET**

(30) Priority: 05.07.2011 JP 2011148822
(71) Applicant: Dexerials Corporation, Tokyo 141-0032 (JP)
(72) Inventor: ITO Yasushi, Kanuma-shi Tochigi 322-8503 (JP); UENO Yoshifumi, Kanuma-shi Tochigi 322-8503 (JP); TANI Hirofumi, Kanuma-shi Tochigi 322-8503 (JP)
(74) Representative: Müller-Boré & Partner Patentanwälte PartG mbB
(86) International application number: PCT/JP2012/067180
(87) International publication number: WO 2013/005793

(57) **Abstract**

A phosphor sheet-forming resin composition uses a low-cost resin material having high light fastness and low visible light absorption and is capable of providing a phosphor sheet at low cost with deterioration of a phosphor due to moisture being suppressed. The resin composition contains a film-forming resin composition and a powdery phosphor that emits fluorescence when irradiated with excitation light. The film-forming resin composition used contains a polyolefin copolymer component and a maleic anhydride component. A sulfurized phosphor, an oxide-based phosphor, or a phosphor mixture thereof is preferably used as the phosphor.

## Description

### Technical Field

The present invention relates to a phosphor sheet-forming resin composition containing a fiim-forming resin composition and a powdery phosphor that emits fluorescence when irradiated with excitation light.

### Background Art

In one conventional attempt to obtain white light, a phosphor sheet, in which a powdery red phosphor that emits red fluorescence when irradiated with blue light and a green phosphor that emits green fluorescence when irradiated with blue light are dispersed in a resin material having high visible light transmittance, is irradiated with light emitted from a blue light-emitting diode (blue LED) so that red light and green light are caused to be emitted from the phosphor sheet irradiated with the blue light, and then the blue light is mixed with red light and green light emitted from irradiated with the blue light to produce white light. (Patent Literature 1).

### Citation List

### Patent Literature

Patent Literature 1: Japanese Patent Application Laid-Open No. 2008-41706

### Summary of Invention

### Technical Problem

However, in such a phosphor sheet, when a low-cost thermoplastic (meth)acrylate-based resin etc. (the term (meth)acrylate includes acrylate and methacrylate) is used as the resin material, the resin material turns yellow due to the blue light, and this causes problems such as a loss of the light power of the blue LED and absorption of the emitted fluorescence. Another problem is that the phosphors deteriorate due to moisture entering the resin material, so that the color of the light emitted from the phosphor sheet changes. Therefore, a silicone resin that has high light fastness and high water vapor permeation resistance but is high cost must be used as the resin material, or the phosphor sheet must be held between high-cost glass substrates from both sides. This poses another problem in that it is difficult to cut down the production cost of the phosphor sheet.

The present invention has been made to solve the foregoing conventional problems, and it is an object of the present invention to provide a phosphor sheet-forming resin composition that uses a low-cost resin material having high light fastness and low visible light absorption and is capable of providing a phosphor sheet at low cost with deterioration of the phosphors due to moisture being suppressed.

### Solution to Problem

The present inventors have found that the above object can be achieved by using, as the film-forming resin composition constituting the phosphor sheet-forming resin composition, a specific resin composition that has high light fastness and low visible light absorption and is available at low cost. Thus, the present invention has been completed.

Accordingly, the present invention provides a phosphor sheet-forming resin composition containing a film-forming resin composition and a powdery phosphor that emits fluorescence when irradiated with excitation light, wherein
the film-forming resin composition contains a polyolefin copolymer component and a maleic anhydride component. Preferred examples of the phosphor include sulfurized phosphors, oxide-based phosphors, and phosphor mixtures thereof.

The present invention also provides a phosphor sheet including a phosphor layer that emits fluorescence when irradiated with excitation light and a pair of transparent substrates that hold the phosphor layer therebetween, wherein the phosphor layer is obtained by forming the above-described phosphor sheet-forming resin composition of the present invention into a film. The present invention also provides a light-emitting device including the above phosphor sheet and an excitation light source that emits excitation light applied to the phosphor sheet. Advantageous Effects of Invention

In the phosphor sheet-forming resin composition of the present invention, a specific resin composition, among many resin compositions, is used as the film-forming resin composition. The specific resin composition contains a maleic anhydride component and a polyolefin copolymer component that has higher light fastness and lower visible light absorption than those of thermoplastic (meth)acrylic-based resins and is available at relatively low cost. Therefore, the phosphor sheet-forming resin composition of the present invention can provide, at low cost, a phosphor sheet that has high light fastness and low visible light absorption with deterioration of the phosphor due to moisture being suppressed. Even when the phosphor sheet is used for a long time, the degree of deviation in chromaticity can be made small, and a reduction in emission spectral intensity can be made small.

### Brief Description of Drawings

FIG. 1 is a cross-sectional view of a single layer-type phosphor sheet.
FIG. 2 is a cross-sectional view of a double layer-type phosphor sheet.
FIG. 3 is a cross-sectional view of a preferred single layer-type phosphor sheet.
FIG. 4 is a cross-sectional view of a preferred double layer-type phosphor sheet.
FIG. 5 is a cross-sectional view of a sealing film.

### Description of Embodiments

The phosphor sheet-forming resin composition of the present invention contains a film-forming resin composition and a powdery phosphor that emits fluorescence when irradiated with excitation light.

The film-forming resin composition contains a polyolefin copolymer component and a maleic anhydride component. The reason that the polyolefin copolymer component is used is that it has higher light fastness and lower water absorption than those of thermoplastic (meth)acrylic-based resins and is available at low cost. When the film-forming resin composition contains the maleic anhydride component, moisture entering the film-forming resin composition is trapped by free carboxyl groups of the maleic anhydride component, so that deterioration of the phosphor due to moisture can be prevented.

If the ratio of the polyolefin copolymer component contained in the film-forming resin composition is too small, the adhesion of the film-forming resin composition tends to be insufficient. If the ratio is too large, part of the polyolefin copolymer component tends not to dissolve in a solvent. Therefore, the ratio of the polyolefin copolymer component is preferably 10 to 40% by mass and more preferably 20 to 30% by mass.

In the present invention, the maleic anhydride component may be added (externally added) to the polyolefin copolymer component as a separate independent component or may be added (internally added) to the polyolefin copolymer component so as to be graft-polymerized therewith. When the maleic anhydride component is internally added, the film-forming resin composition contains a maleic anhydride-modified polyolefin copolymer. External addition is more preferred than internal addition, because yellowing of the film-forming resin composition can be suppressed more.

When the maleic anhydride component is externally added, if the ratio of the maleic anhydride component to the polyolefin copolymer component in the film-forming resin composition is too large, the phosphor sheet tends to be colored. If the ratio is too small, the moisture trapping effect by the maleic anhydride component tends not to be obtained. Therefore, the ratio of the maleic anhydride component contained in the film-forming resin composition is preferably 0.3 to 30 parts by mass based on 100 parts by mass of the polyolefin copolymer component and more preferably 0.3 to 3 parts by mass.

When the maleic anhydride component is internally added, if the ratio of the maleic anhydride residue in the maleic anhydride-modified polyolefin copolymer is too large, the phosphor sheet tends to be colored. If the ratio is too small, the moisture trapping effect by the maleic anhydride residue tends not to be obtained. Therefore, the film-forming resin composition contains the maleic anhydride component in the maleic anhydride-modified polyolefin copolymer at a ratio of preferably 0.3 to 30 mol% and more preferably 0.3 to 3 mol%.

Any of various polyolefin copolymers can be used as the polyolefin copolymer. Preferred examples thereof include styrene-based copolymers and hydrogenated products thereof. Preferred examples of such styrene-based copolymers and hydrogenated products thereof include: styrene-butadiene-styrene block copolymers and hydrogenated products thereof; styrene-ethylene-butylene-styrene block copolymers and hydrogenated products thereof; styrene-ethylene-propylene-styrene block copolymers and hydrogenated products thereof; and styreneisoprene-styrene block copolymers and hydrogenated products thereof. Of these, hydrogenated products of styrene-ethylene-butylene-styrene block copolymers can be particularly preferably used because of their high transparency to visible light and their high barrier properties against water vapor and oxygen.

The ratio of the styrene unit contained in such a styrene-based copolymer is preferably 20 to 30 mol%. When the ratio falls within this range, favorable mechanical strength can be imparted to the phosphor sheet.

If the hydrogenation ratio of the styrene-based copolymer is too low, the light fastness of the phosphor sheet tends to become low. Therefore, the hydrogenation ratio is preferably at least 50% and more preferably 95%.

In the present invention, the phosphor used is a powdery phosphor (with an average particle diameter of generally 3 to 20 µm) that, when irradiated with excitation light, emits fluorescence (fluorescence having a wavelength longer than that of the excitation light). This phosphor is a sulfurized phosphor, an oxide-based phosphor, or a phosphor mixture thereof. Light having a wavelength that can excite the phosphor used to cause it to emit fluorescence may be appropriately selected as the excitation light. When the phosphor sheet emits white light, blue light having a light emission peak at a wavelength of 440 to 470 nm is preferably used. Preferably, a known blue LED is used as the light source of the blue light.

Examples of the sulfurized phosphor include: sulfurized phosphors, preferably CaS:Eu and SrS:Eu, that have a red fluorescent peak at 620 to 660 nm when irradiated with blue excitation light; and sulfurized phosphors, preferably SrGa₂S₄:Eu, that have a green fluorescent peak at 530 to 550 nm when irradiated with blue excitation light.

Examples of the oxide-based phosphor include oxide-based phosphors, such as preferably (BaSr)₃SiO₅:Eu and (BaSr)₂SiO₄:Eu, that have a red fluorescent peak at 620 to 660 nm when irradiated with blue excitation light.

The phosphor used may be a mixture of any of the above phosphors. In such a case, in order for the phosphor sheet to emit white light, it is preferable to use a phosphor mixture of a sulfurized phosphor that has a green fluorescent peak at 530 to 550 nm when irradiated with blue excitation light, and a sulfurized phosphor that has a red fluorescent peak at 620 to 660 nm when irradiated with the blue excitation light or an oxide-based phosphor that has a red fluorescent peak at 590 to 620 nm when irradiated with the blue excitation light. A particularly preferred combination is a phosphor mixture of CaS:Eu or (BaSr)₃SiO₅:Eu that emits red fluorescence with SrGa₂S₄:Eu that emits green fluorescence.

In the present invention, if the ratio of the phosphor mixed with the film-forming resin composition is small, the amount of the resin component used as the film-forming component increases relatively. Therefore, the thickness of a coating film applied using a coater tends to be thicker than a prescribed thickness. To reduce the thickness, the amount of a volatile solvent must be increased. On the other hand, if the ratio of the phosphor mixed is large, the amount of the resin component decreases relatively. Therefore, the thickness of the coating film tends to be thinner than the prescribed thickness. In addition, since the concentration of the phosphor relative to the resin is high, unevenness in concentration increases if kneading is insufficient. Therefore, the ratio of the phosphor mixed with the film-forming resin composition is preferably 1 to 10 parts by mass based on 100 parts by mass of the film-forming resin composition and more preferably 1 to 6 parts by mass.

If necessary, other light-transmitting resins such as (meth)acrylic-based resins, color pigments, solvents, etc. may be added to the phosphor sheet-forming resin composition of the present invention within a range in which the effects of the present invention are not impaired.

The phosphor sheet-forming resin composition of the present invention can be prepared by mixing the film-forming resin composition and the powdery phosphor by a routine method.

Next, a phosphor sheet using the phosphor sheet-forming resin composition of the present invention will be described with reference to the drawings.

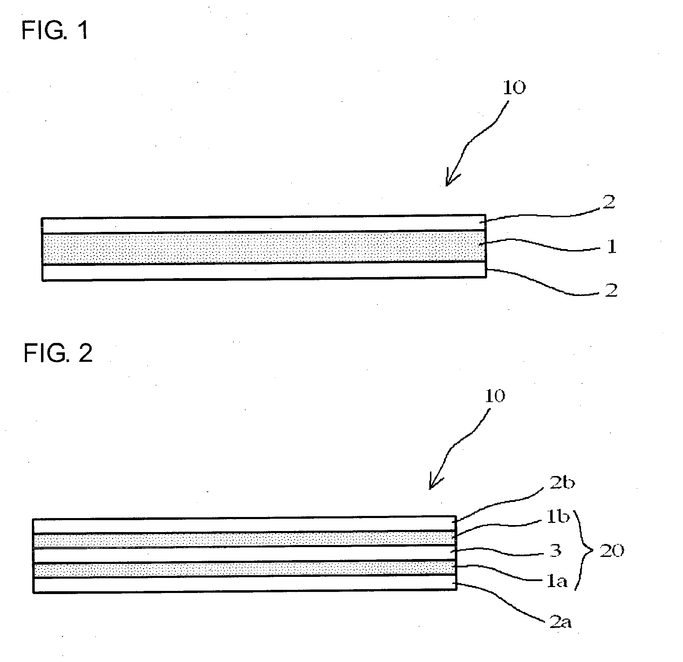

As shown in FIG. 1, the phosphor sheet of the present invention is a phosphor sheet 10 in which a single phosphor layer 1 that emits fluorescence when irradiated with excitation light is sandwiched between a pair of transparent substrates 2. The phosphor layer 1 is formed by depositing the above-described phosphor sheet-forming resin composition of the present invention.

FIG. 1 shows an example in which the phosphor layer 1 being a single layer is used. However, as shown in FIG. 2, a stacked phosphor layer 20 having a double layer structure in which two phosphor layers 1a and 1b are stacked with a transparent separator 3 interposed therebetween may be used. Also in this case, the stacked phosphor layer 20 is sandwiched between a pair of transparent substrates 2a and 2b. In such a double layer structure, phosphors that easily react with each other (for example, CaS:Eu and SrGa₂S₄:Eu) can be disposed in different layers, and the phosphors and the film-forming resin composition components can be disposed in different layers. Therefore, unintended reactions therebetween can be suppressed, so that the life of the phosphor sheet can be extended. Preferably, in this case, one of the phosphor layers 1a and 1b is formed from a red emitting phosphor sheet-forming resin composition containing a sulfurized phosphor (preferably CaS:Eu) that has a red fluorescent peak at 620 to 660 nm when irradiated with blue excitation light or an oxide-based phosphor (preferably (BaSr)₃SiO₅:Eu) that has a red fluorescent peak at 590 to 620 nm when irradiated with the blue excitation light, and the other is formed from a green emitting phosphor sheet-forming resin composition containing a sulfurized phosphor (preferably SrGa₂S₄:Eu) having a green fluorescent peak at 530 to 550 nm when irradiated with the blue excitation light.

If the thicknesses of the phosphor layers 1, 1a, and 1b are too small, the absolute amounts of the phosphors become small accordingly, so that the light emission intensity tends to be insufficient. On the other hand, if the thicknesses are too large, the target chromaticity tends not to be obtained. Therefore, the thicknesses of the phosphor layers are preferably 20 to 150 µm and more preferably 60 to 150 µm.

Thermoplastic resin films and thermosetting or photocurable resin films having a thickness of 10 to 100 µm can be used as the transparent substrates 2a and 2b and the transparent separator 3. Examples of such films include polyester films, polyamide films, polyimide films, polysulfone films, triacetylcellulose films, and polyolefin films. If necessary, the surfaces of these films may be subjected to a corona discharge treatment, a silane coupling agent treatment, etc., in order to improve adhesion to the phosphor sheet-forming resin composition.

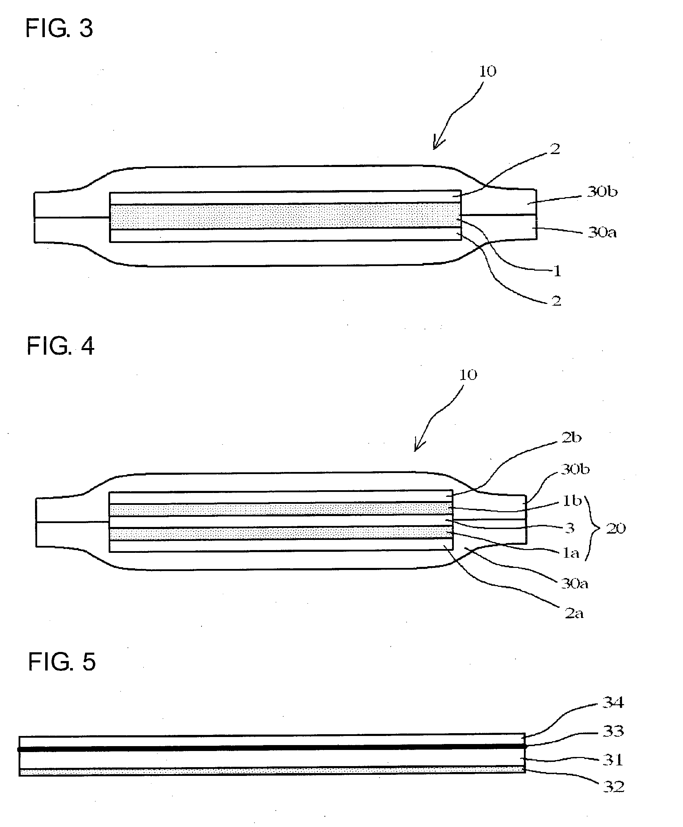

In the present invention, it is preferable to seal the phosphor sheets 10 in FIGs. 1 and 2 with two sealing films 30a and 30b from respective sides, as shown in FIGs. 3 and 4. In this manner, moisture can be further prevented from entering the phosphor layers 1, 1a, and 1b. In this case, it is preferable to perform sealing such that the side faces of the phosphor sheet 10 are not exposed.

A film prepared by forming an adhesive layer 32 on a base film 31 as shown in FIG. 5 can be used as each of the sealing films 30a and 30b. To improve the water vapor barrier properties of the sealing films 30a and 30b, a silicon oxide layer 33 having a thickness of 5 to 20 nm may be formed on the surface of the base film 31 that faces the adhesive layer 32 or the surface opposite to the adhesive layer 32 by, for example, vapor deposition. In the latter case, a surface protective film 34 may be stacked on the silicon oxide layer 33 through an adhesive layer (not shown).

Any film appropriately selected from the films exemplified for the transparent substrates 2a and 2b and the transparent separator 3 described above may be used as each of the base film 31 and the surface protective film 34.

The adhesive layer 32 and the adhesive layer used to stack the surface protective film 34 may be selected from known adhesives such as urethane-based adhesives and acrylic-based adhesives. The thickness of the adhesive layer 32 is generally 10 to 50 µm.

The single layer-type phosphor sheet 10 of the present invention shown in FIG. 1 can be produced by depositing a phosphor sheet-forming resin composition on a transparent substrate 2 by a routine method to form the phosphor layer 1 and then stacking another transparent substrate 2 thereon. A phosphor sheet 10 having the structure shown in FIG. 3 can be produced by sandwiching the above-produced phosphor sheet 10 between the sealing films 30a and 30b from both sides such that the adhesive layers 32 face inward and then subjecting the entire product to thermocompression bonding.

The double layer-type phosphor sheet 10 of the present invention shown in FIG. 2 can be produced by depositing a phosphor sheet-forming resin composition on a transparent substrate 2a by a routine method to form a phosphor layer 1a, stacking a transparent separator 3 thereon, depositing thereon another phosphor sheet-forming resin composition containing a phosphor different from the phosphor in the previously deposited phosphor sheet-forming resin composition by a routine method to form a phosphor layer 1b, and then stacking the transparent substrate 2b thereon. A phosphor sheet 10 having the structure shown in FIG. 4 can be produced by sandwiching the above-produced phosphor sheet 10 between the sealing films 30a and 30b from both sides such that the adhesive layers 32 face inward and then subjecting the entire product to thermocompression bonding.

Preferably, both the two layers constituting the above double layer-type phosphor sheet 10 are formed from phosphor sheet-forming resin compositions of the present invention containing the polyolefin copolymer component and maleic anhydride component described above. However, one of these layers used may be formed from a phosphor sheet-forming resin composition in which a phosphor is dispersed in a film-forming composition containing a photocurable (meth)acrylate. This is because, since the photocurable (meth)acrylate has an ester group having water trapping properties, although their level is lower than that of the maleic anhydride component, the effects of the phosphor sheet-forming resin composition of the present invention are not significantly impaired.

Examples of such a photocurable (meth)acrylate include urethane (meth)acrylate, polyester (meth)acrylate, and epoxy acrylate. Of these, urethane (meth)acrylate can be preferably used because of its light fastness.

Preferred examples of the urethane (meth)acrylate include those obtained by esterifying a reaction product of a polyol (preferably a polyether polyol, a polyolefin polyol, a polyester polyol, or a polycarbonate polyol) and a diisocyanate compound (preferably isophorone diisocyanate) with a hydroxyalkyl (meth)acrylate (preferably 2-hydroxypropyl acrylate).

If the amount of the urethane (meth)acrylate contained in the photocurable (meth)acrylate is too small, adhesion tends to become low. Therefore, the urethane (meth)acrylate is contained in an amount of preferably at least 10 parts by mass based on 100 parts by mass of the photocurable (meth)acrylate and more preferably at least 30 parts by mass.

The film-forming composition containing the photocurable (meth)acrylate generally contains a photopolymerization initiator. Examples of such a photopolymerization initiator include: radical photopolymerization initiators such as alkylphenone-based photopolymerization initiators, acylphosphine oxide-based photopolymerization initiators, titanocene-based photopolymerization initiators, oxime ester-based photopolymerization initiators, and oxyphenyl acetate-based photopolymerization initiators; and cationic photopolymerization initiators such as diazonium-based photopolymerization initiators, iodonium-based photopolymerization initiators, and sulfonium-based photopolymerization initiators. The amount of such a photopolymerization initiator used is preferably 0.1 to 10 parts by mass based on 100 parts by mass of the photocurable (meth)acrylate and more preferably 1 to 10 parts by mass.

The phosphor sheet of the present invention described above can be preferably used as a phosphor sheet of a light emitting device including the phosphor sheet and an excitation light source for emitting excitation light applied to the phosphor sheet. The configuration of other components constituting such an optical device (for example, a light diffusing member) may be the same as the configuration of a known optical device (refer to FIG. 6 in Japanese Patent Application Laid-Open No. 2010-225373). This light emitting device itself can be used as a lighting device. The light emitting device can also be used as a backlight of a liquid crystal display device.

### Examples

The present invention will next be specifically described by way of Examples.

### Example 1 (Production of single layer-type phosphor sheet) (Preparation of green phosphor sheet-forming resin composition)

100 parts by mass of toluene, 40 parts by mass of a hydrogenated styrene-ethylene-butylene-styrene block (hydrogenated SEBS) copolymer (SEPTON V9827, KURARAY Co., Ltd.), and 0.5 parts by mass of maleic anhydride were uniformly mixed. Then 2 parts by mass of SrGa₂S₄:Eu (sulfurized green phosphor) having an average particle diameter of 6 µm was uniformly dispersed in the obtained mixture to thereby prepare a green phosphor sheet-forming resin composition.

### (Production of phosphor sheet having structure in FIG. 1)

The phosphor sheet-forming resin composition was applied to a 25 µm-thick polyethylene terephthalate film (T11, TORAY INDUSTRIES, Inc.) to a dry thickness of 100 µm and subjected to a drying treatment (100°C, 5 minutes) to form a phosphor layer. A 25 µm-thick polyethylene terephthalate film (T11, TORAY INDUSTRIES, Inc.) was stacked on the phosphor layer, and a thermocompression bonding treatment (100°C, 0.2 MPa) was performed thereon to obtain a green phosphor sheet having the structure in FIG. 1.

### (Production of sealing films)

A polyolefin-based adhesive layer (SEPTON V9827, KURARAY Co., Ltd.) having a thickness of 20 to 25 µm was formed on one side of a 25 µm-thick polyethylene terephthalate film (T-11, TORAY INDUSTRIES, Inc.). A surface protective film having a urethane-based adhesive layer formed thereon was stacked on the other side of the polyethylene terephthalate film through the urethane-based adhesive layer to thereby produce a sealing film. The surface protective film was produced by forming the urethane-based adhesive layer having a thickness of 1 to 2 µm on a vapor-deposited silicon oxide layer having a thickness of about 20 nm and formed on a 12 µm-thick polyethylene terephthalate film (TECHBARRIER, Mitsubishi Plastics, Inc.). The moisture permeability of the obtained sealing film was 0.3 g/m²·24 hr·atm.

### (Production of phosphor sheet having structure in FIG. 3)

The sealing films were disposed on respective sides of the phosphor sheet having the structure in FIG. 1, and the resultant product was subjected to a thermocompression bonding treatment (100°C, 0.2 MPa) to thereby obtain a green phosphor sheet sealed with the sealing films.

### Example 2 (Production of single layer-type phosphor sheet)

A red phosphor sheet-forming resin composition was prepared in the same manner as in Example 1 except that CaS:Eu having an average particle diameter of 9 µm and serving as a sulfurized red phosphor was used instead of SrGa₂S₄:Eu serving as the green phosphor. Then red phosphor sheets having the structures in FIGs. 1 and 3 were produced in the same manner as in Example 1.

### Example 3 (Production of double layer-type phosphor sheet)

### (Preparation of green phosphor sheet-forming resin composition)

0.5 parts by mass of a photopolymerization initiator (DAROCUR 1173, manufacture by BASF) and 1.5 parts by mass of SrGa₂S₄:Eu (sulfurized green phosphor) having an average particle diameter of 6 µm were uniformly dispersed in 100 parts by mass of a photocurable urethane methacrylate (ARONIX M1600, TOAGOSEI Co., Ltd.) to thereby prepare a green phosphor sheet-forming resin composition.

### (Preparation of red phosphor sheet-forming resin composition)

100 parts by mass of toluene, 40 parts by mass of a hydrogenated styrene-ethylene-butylene-styrene block (hydrogenated SEBS) copolymer (SEPTON V9827, KURARAY Co., Ltd.), and 0.5 parts by mass of maleic anhydride were uniformly mixed. Then 2 parts by mass of CaS:Eu (sulfurized red phosphor) having an average particle diameter of 9 µm and serving as a sulfurized red phosphor was uniformly dispersed in the obtained mixture to thereby prepare a red phosphor sheet-forming resin composition.

### (Production of phosphor sheet having structure in FIG. 2)

The green phosphor sheet-forming resin composition was applied to a 25 µm-thick polyethylene terephthalate film (T11, TORAY INDUSTRIES, Inc.) to a dry thickness of 115 µm and then irradiated with ultraviolet rays (7,000 mJ/cm²) to polymerize the urethane methacrylate, whereby a phosphor layer was formed. A 38 µm-thick transparent separator (polyethylene terephthalate film (A4300, TOYOBO Co., Ltd.)) was stacked on the phosphor layer and subjected to a thermocompression bonding treatment (100°C, 20 Pa). The red phosphor sheet-forming resin composition was applied to the treated transparent separator to a dry thickness of 20 µm and then subjected to a drying treatment (100°C, 5 minutes) to form a phosphor layer. A 25 µm-thick polyethylene terephthalate film (T11, TORAY INDUSTRIES, Inc.) was stacked on the phosphor layer, and a thermocompression bonding treatment (100°C, 0.2 MPa) was performed thereon to obtain a phosphor sheet having the structure in FIG. 2.

### (Production of phosphor sheet having structure in FIG. 4)

The same sealing films as those used in Example 1 were disposed on respective sides of the phosphor sheet having the structure in FIG. 2, and a thermocompression bonding treatment (100°C, 0.2 MPa) was performed thereon to obtain a phosphor sheet sealed with the sealing films.

### Example 4 (Production of double layer-type phosphor sheet)

### (Preparation of green phosphor sheet-forming resin composition)

A green phosphor sheet-forming resin composition was prepared in the same manner as in Example 1.

### (Preparation of red phosphor sheet-forming resin composition)

A red phosphor sheet-forming resin composition was prepared in the same manner as in Example 2.

### (Production of phosphor sheet having structure in FIG. 2)

A phosphor sheet having the structure in FIG. 2 was obtained in the same manner as in Example 3 except that the above green phosphor sheet-forming resin composition and the above red phosphor sheet-forming resin composition were used.

### (Production of phosphor sheet having structure in FIG. 4)

The same sealing films as those used in Example 1 were disposed on respective sides of the phosphor sheet having the structure in FIG. 2, and a thermocompression bonding treatment (100°C, 0.2 MPa) was performed thereon to obtain a phosphor sheet sealed with the sealing films.

### Comparative Example 1

A red phosphor sheet-forming resin composition was prepared in the same manner as in Example 2 except that a butyl methacrylate-glycidyl methacrylate (BMA-GMA) copolymer (DF-242, Fujikura Kasei Co., Ltd.) was used instead of the hydrogenated SEBS copolymer resin and that no maleic anhydride was used. Then red phosphor sheets having the structures in FIGs. 1 and 3 were produced.

### Comparative Example 2

A green phosphor sheet-forming resin composition was prepared in the same manner as in Example 1 except that no maleic anhydride was used. Then green phosphor sheets having the structures in FIGs. 1 and 3 were produced.

### Comparative Example 3

A phosphor sheet-forming resin composition was prepared in the same manner as in Example 1 except that a BMA-GMA copolymer (DF-242, Fujikura Kasei Co., Ltd.) was used instead of the hydrogenated SEBS copolymer resin and that no maleic anhydride was used. Then phosphor sheets having the structures in FIGs. 2 and 4 were produced.

### (Evaluation)

Each of the sealed phosphor sheets in the Examples and Comparative Examples was evaluated as follows. More specifically, for each single layer-type phosphor sheet, the light emission spectral intensity ratio was measured and evaluated. For each double layer-type phosphor sheet, the difference in chromaticity was measured and evaluated. The results obtained are shown in TABLE 1.

### <Light emission spectral intensity ratio>

Each of the obtained sealed phosphor sheets was left to stand in an environment of 85°C and 85%Rh for 48 hours. Then the light emission spectral intensity (SR) was measured before and after the sheet was left to stand using a spectroradiometer (TOPCON SR-3, TOPCON Corporation), and the ratio of the light emission spectral intensity (SR) after the sheet was left to stand to the light emission spectral intensity (SR) before the sheet was left to stand was determined and evaluated according to the following criteria. It is practically desirable that the SR ratio be 0.7 or higher (A rating).

### Rank: Criterion

A: 0.7 ≤ SR ratio
B: 0.5 ≤ SR ratio < 0.7
C: SR ratio < 0.5

### <Difference in chromaticity (deviation in chromaticity)>

Each of the obtained sealed phosphor sheets was left to stand in an environment of 60°C and 90%Rh for 500 hours. The difference in chromaticity (JIS Z8518) Δu'v' before and after the sheet was left to stand was determined and evaluated according to the following criteria.

### Rank: Criterion

S: Δu'v' < 0.002
A: 0.002 ≤ Δu'v' < 0.005
B: 0.005 ≤ Δu'v' < 0.010
C: 0.010 ≤ Δu'v'

**[TABLE 1]**

| | Example | | | | | | | | Comparative Example | | |
|---|---|---|---|---|---|---|---|---|---|---|---|
| | Single Layer-Type Phosphor Sheet | | Double Layer-Type Phosphor Sheet | | | | | | Single Layer-Type Phosphor Sheet | | |
| | 1 | 2 | 3 | | | 4 | | | 1 | 2 | 3 |
| Resin Used | Hydrogenated SEBS + Maleic Anhydride | Hydrogenated SEBS + Maleic Anhydride | Photocurable Acrylate | Hydrogenated SEBS + Maleic Anhydride | | Hydrogenated SEBS + Maleic Anhydride | Hydrogenated SEBS + Maleic Anhydride | | BMA-GMA | Hydrogenated SEBS | BMA-GMA |
| Green Phosphor | SrGa₂S₄:Eu | - | SrGa₂S₄:Eu | - | | SrGa₂S₄:Eu | - | | - | SrGa₂S₄:Eu | SrGa₂S₄:Eu |
| Red Phosphor | - | CaS:Eu | - | CaS:Eu | | - | CaS:Eu | | CaS:Eu | - | - |
| Difference in Chromaticity | - | - | S (0.0006) | | | S (0.0006) | | | - | - | - |
| Light Emission Spectral Intensity Ratio | A(0.81) | A (0.91) | - | | - | - | | - | C(0.4) | C (0.32) | B (0.66) |

As can be seen from TABLE 1, in the single layer-type phosphor sheets in Examples 1 and 2, the light emission spectral intensity ratio was rated A. In the double layer-type phosphor sheets in Examples 3 and 4, the difference in chromaticity (deviation in chromaticity) was rated S. However, in the phosphor sheets in Comparative Examples 1 to 3, since no maleic anhydride was used and the BMA-GMA copolymer or the hydrogenated SEBS copolymer resin was used as the film-forming resin composition, the light emission spectral intensity ratio was rated B or C.

### Industrial Applicability

The phosphor sheet-forming resin composition of the present invention uses, as the film-forming resin composition, a specific resin composition selected from many resin compositions and containing a maleic anhydride component and a polyolefin copolymer component that has higher light fastness and lower visible light absorption than those of epoxy resins etc. and is available at relatively low cost. Therefore, the phosphor sheet-forming resin composition of the present invention is useful as a raw material for producing a low cost phosphor sheet that has high light fastness and low visible light absorption with deterioration of the phosphor due to moisture being suppressed.

### Reference Signs List

- 1, 1a, 1b: Phosphor layer
- 2, 2a, 2b: Transparent substrate
- 3: Transparent separator
- 10: Phosphor sheet
- 20: Stacked phosphor layer
- 30a, 30b: Sealing film
- 31: Base film
- 32: Adhesive layer
- 33: Silicon oxide layer
- 34: Surface protective film

## Claims

1. A phosphor sheet-forming resin composition comprising a film-forming resin composition and a powdery phosphor that emits fluorescence when irradiated with excitation light, wherein
the film-forming resin composition contains a polyolefin copolymer component and a maleic anhydride component.

2. The phosphor sheet-forming resin composition according to claim 1, wherein the phosphor is a sulfurized phosphor, an oxide-based phosphor, or a phosphor mixture thereof.

3. The phosphor sheet-forming resin composition according to claim 1 or 2, wherein the film-forming resin composition contains the polyolefin copolymer component and the maleic anhydride component externally added thereto.

4. The phosphor sheet-forming resin composition according to any one of claims 1 to 3, wherein a ratio of the maleic anhydride component externally added to the film-forming resin composition is 0.3 to 30 parts by mass based on 100 parts by mass of the polyolefin copolymer component.

5. The phosphor sheet-forming resin composition according to any one of claims 1 to 3, wherein a ratio of the maleic anhydride component externally added to the film-forming resin composition is 0.3 to 3 parts by mass based on 100 parts by mass of the polyolefin copolymer component.

6. The phosphor sheet-forming resin composition according to claim 1 or 2, wherein the film-forming resin composition contains a maleic anhydride-modified polyolefin copolymer constituted by the polyolefin copolymer component and the maleic anhydride component that is graft-polymerized with the polyolefin copolymer component.

7. The phosphor sheet-forming resin composition according to claim 6, wherein the film-forming resin composition contains a maleic anhydride residue in the maleic anhydride-modified polyolefin copolymer at a ratio of 0.3 to 30 mol%.

8. The phosphor sheet-forming resin composition according to claim 6, wherein the film-forming resin composition contains a maleic anhydride residue in the maleic anhydride-modified polyolefin copolymer at a ratio of 0.3 to 3 mol%.

9. The phosphor sheet-forming resin composition according to any one of claims 1 to 8, wherein the polyolefin copolymer is a hydrogenated styrene-based copolymer.

10. The phosphor sheet-forming resin composition according to any one of claims 1 to 9, wherein the phosphor is a sulfurized phosphor that has a red fluorescent peak at 620 to 660 nm when irradiated with blue excitation light.

11. The phosphor sheet-forming resin composition according to claim 10, wherein the sulfurized phosphor is CaS:Eu.

12. The phosphor sheet-forming resin composition according to any one of claims 1 to 9, wherein the phosphor is a sulfurized phosphor that has a green fluorescent peak at 530 to 550 nm when irradiated with blue excitation light.

13. The phosphor sheet-forming resin composition according to claim 12, wherein the sulfurized phosphor is SrGa₂S₄:Eu.

14. The phosphor sheet-forming resin composition according to any one of claims 1 to 9, wherein the phosphor is a phosphor mixture of a sulfurized phosphor that has a green fluorescent peak at 530 to 550 nm when irradiated with blue excitation light, and a sulfurized phosphor that has a red fluorescent peak at 620 to 660 nm when irradiated with the blue excitation light or an oxide-based phosphor that has a red fluorescent peak at 590 to 630 nm when irradiated with the blue excitation light.

15. The phosphor sheet-forming resin composition according to claim 14, wherein the sulfurized phosphor that emits red fluorescence is CaS:Eu, the oxide-based phosphor that emits red fluorescence is (BaSr)₃SiO₅:Eu, and the sulfurized phosphor that emits green fluorescence is SrGa₂S₄:Eu.

16. A phosphor sheet comprising a phosphor layer that emits fluorescence when irradiated with excitation light and a pair of transparent substrates that hold the phosphor layer therebetween, wherein the phosphor layer is obtained by forming the phosphor sheet-forming resin composition of claim 1 into a film.

17. The phosphor sheet according to claim 16, wherein the phosphor layer is formed by depositing the phosphor sheet-forming resin composition according to claim 14 or 15 into a single layer.

18. The phosphor sheet according to claim 16, wherein the phosphor layer has a structure obtained by depositing a red phosphor layer on one side of a transparent separator layer, the red phosphor layer being formed as a single layer from the phosphor sheet-forming resin composition according to claim 10 or 11, and depositing a green phosphor layer on the other side of the transparent separator layer, the green phosphor layer being formed as a single layer from the phosphor sheet-forming resin composition according to claim 12 or 13.

19. The phosphor sheet according to any one of claims 16 to 18, wherein the phosphor sheet is further sealed with two sealing films from respective sides, the sealing film having an adhesive layer on one side thereof.

20. A light-emitting device comprising: the phosphor sheet according to any one of claims 16 to 19; and an excitation light source that emits excitation light applied to the phosphor sheet.
